# EUROPEAN PATENT APPLICATION

(11) **EP 2 276 054 A1**
(43) Date of publication of application: **19.01.2011**
(21) Application number: 09165334.5
(22) Date of filing: 13.07.2009
(51) Int. Cl.: H01J 37/34

(54) **Sputtering system, rotatable cylindrical target assembly, backing tube, target element and cooling shield**

(71) Applicant: Applied Materials, Inc., Santa Clara, CA 95054 (US)
(72) Inventor: Schnappenberger, Frank, 55218 Ingelheim (DE); Weber, Roland, 63755 Alzenau (DE); Krempel-Hesse, Joerg, 63694 Limeshain (DE); Hellmich, Anke, 63796 Kahl (DE)
(74) Representative: Zimmermann & Partner

(57) **Abstract**

The application concerns a target backing tube for a rotatable cylindrical target assembly (120) comprising: a tube (122a) for at least one target element (126a) to be disposed there around, wherein the tube has an exterior surface adapted to face the at least one target element, wherein a portion of the exterior surface of the tube has a mean emissivity of 0.7 to 1, wherein the portion is at least 50% of the exterior surface of the tube. Further, the application concerns a cooling shield for a sputtering system comprising a rotatable target, the cooling shield has an interior surface adapted to face a target element of a sputtering system and an exterior surface; wherein a portion of the interior surface of the cooling shield has a mean emissivity of 0.7 to 1, wherein the portion is at least 50% of the interior surface of the cooling shield. Additionally, the application concerns a target element for a rotatable cylindrical target assembly of a sputtering system, wherein the target element an interior surface adapted to face a target backing tube onto which the target cylinder is adapted to be disposed and exterior surface, wherein a portion of the interior surface of the target element has a mean emissivity of 0.7 to 1, wherein the portion is at least 50% of the interior surface of the target element.

## Description

The present disclosure relates to a sputtering system. More specifically, the present disclose relates to a sputtering system including a rotatable cylindrical target assembly including a target backing tube and at least one target element, and a least one cooling shield. Further, the present disclosure relates to a rotatable cylindrical target assembly. More specifically, the present disclosure relates to a rotatable cylindrical target assembly including a backing tube and at least one target element disposed around the backing tube. According to some embodiments, the present disclosure relates to cooling shield, in particular for a sputtering system including a rotatable target. Additionally, the present disclosure relates to a target element, in particular for a rotatable cylindrical target assembly of a sputtering system. Further, the present disclosure relates to target backing tube for a rotatable cylindrical target assembly.

### BACKGROUND

In many applications, it is necessary to deposit thin layers on a substrate. The term "substrate" as used herein shall embrace both inflexible substrates, e.g. a wafer or a glass plate, and flexible substrates such as webs and foils. Known techniques for depositing layers are in particular evaporating, sputtering and chemical vapor deposition.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer such as a thin layer of aluminum or ceramics. During the sputtering process, the coating material is transported from a target consisting of that material to the substrate to be coated by bombarding the surface of the target with ions of an inert gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

### SUMMARY

In light of the above, a target backing tube for a rotatable target according to independent claim 1, a target cylinder for a rotatable cylindrical target assembly of a sputtering system according to independent claim 6, a cooling shield for a sputtering system comprising a rotatable target according to independent claim 12, a rotatable cylindrical target assembly according to claim 19 and a sputtering system according to claim 23 are provided.

According to one embodiment, target backing tube for a rotatable cylindrical target assembly is provided including: a tube for at least one target element to be disposed there around, wherein the tube has an exterior surface adapted to face the at least one target element, wherein a portion of the exterior surface of the backing tube has a mean emissivity of 0.7 to 1, wherein the portion is at least 50% of the exterior surface of the backing tube.

According to an embodiment, the portion is at least 70%, in particular at least 90%, of the exterior surface of the tube.

Typically, in an embodiment, the portion of the surface of the tube has a coating presenting the mean emissivity of 0.7 to 1.

In an embodiment, which may be combined with other embodiments disclosed herein, the portion of the exterior surface of the tube is coated with a material selected from the group consisting of TiO₂, CrO, Carbon, Graphite, and any combination thereof..

Typically, the portion of the exterior surface has a roughness between R_{z} 20 and R_{z} 500, in particular between R_{z} 50 and R_{z} 250.

According to a further embodiment, a target element for a rotatable cylindrical target assembly of a sputtering system is provided, wherein the target element an interior surface adapted to face a target backing tube onto which the target cylinder is adapted to be disposed and exterior surface, wherein a portion of the interior surface of the target element has a mean emissivity of 0.7 to 1, wherein the portion is at least 50% of the interior surface of the target element.

In a typical embodiment, the portion is at least 70%, in particular at least 90%, of the interior surface of the target element.

In an embodiment, which may be combined with other embodiments disclosed herein, the portion of the surface of the target element has a coating presenting the mean emissivity of 0.7 to 1.

Typically, the portion of the interior surface of the target element is coated with a material selected from the group consisting of TiO₂, CrO, Carbon, Graphite, and any combinations thereof..

An an embodiment, the portion of the interior surface has a roughness between R_{z} 20 and R_{z} 500, in particular between R_{z} 50 and R_{z} 250.

In a typical embodiment, the target element is selected from the group consisting of an indium-tin oxide (ITO) target element, a SnO target element, an AlSnO target element, and an InGaSnO target element.

According to yet another embodiment, a cooling shield for a sputtering system is provided including a rotatable target, the cooling shield has an interior surface adapted to face a target element of a sputtering system and an exterior surface; wherein a portion of the interior surface of the target element has a mean emissivity of 0.7 to 1, wherein the portion is at least 50% of the interior surface of the target element.

Typically, the portion is at least 70%, in particular at least 90%, of the interior surface of the cooling shield.

In an embodiment, the portion of the surface of the cooling shield has a coating presenting the mean emissivity of 0.7 to 1.

In a typical embodiment, the portion of the interior surface of the cooling shield is coated with a material selected from the group consisting of TiO₂, CrO, Carbon, Graphite, and any combinations thereof.

Typically, the portion of the interior surface of the cooling shield has a roughness between R_{z} 20 and R_{z} 500, in particular between R_{z} 50 and R_{z} 250.

In an embodiment, the cooling shield may comprise at least one active cooling device, in particular disposed on the exterior surface of the cooling shield or in the cooling shield.

In a typical embodiment, the cooling device is a tube for circulating a cooling fluid and/or an electrical cooling device.

According to a further aspect a rotatable cylindrical target assembly is provided comprising: a target backing tube according to an embodiment disclosed herein and at least one target element disposed around the backing tube.

In a typical embodiment, the at least one target element is a target element according to claims 6 to 10.

The rotatable cylindrical target assembly may typically further comprise a heat transfer gas inlet adapted for providing a heat transfer gas in a space between the exterior surface of the backing tube and the interior surface of the target element, wherein in particular the space is sealed with respect to a surrounding of the rotatable cylindrical target assembly, in particular a vacuum chamber in which the rotatable cylindrical target assembly is disposed.

In an embodiment, which may be combined with other embodiments disclosed herein, the gas is selected from the group consisting of Argon, Helium, process gases, and any combinations thereof.

According to a further aspect, a sputtering system is provided comprising: a rotatable cylindrical target assembly comprising a target backing tube and at least one target element disposed around the target backing tube, and at least one cooling shield according to an embodiment disclosed herein, wherein the cooling shield is provided to surround the at least one target element at a radial position substantially opposite to a substrate to be coated by sputtering.

Typically, the distance between the inner surface of the cooling shield and the outer surface of the at least one target cylinder is about 5 to 200 mm, in particular between 50 and 100 mm.

In an embodiment, the cooling shield surrounds substantially 30 to 80 % of the circumference of the at least one target cylinder, in particular 40 to 60%.

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows a cross-section of an embodiment of a sputtering system;
Fig. 2 shows a transversal cross-section of an embodiment of a cylindrical target assembly;
Fig. 3 shows a transversal cross-section of a further embodiment of a cylindrical target assembly;
Fig. 4 shows a transversal cross-section of another embodiment of a cylindrical target assembly;
Fig. 5 shows a longitudinal cross-section of an embodiment of a cylindrical target assembly;
Fig. 6 shows a schematically cross-section of an embodiment of a sputtering system;
Fig. 7 shows a cross-section of an embodiment of a cooling shield;
Fig. 8 shows schematically a perspective view of a further embodiment of a cooling shield; and
Fig. 9 shows a cross-section of another embodiment of a cooling shield.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

The process of coating a substrate as a material at the scraping refers typically to thin film applications. The term "coating" and the term "depositing" are used synonymously herein.

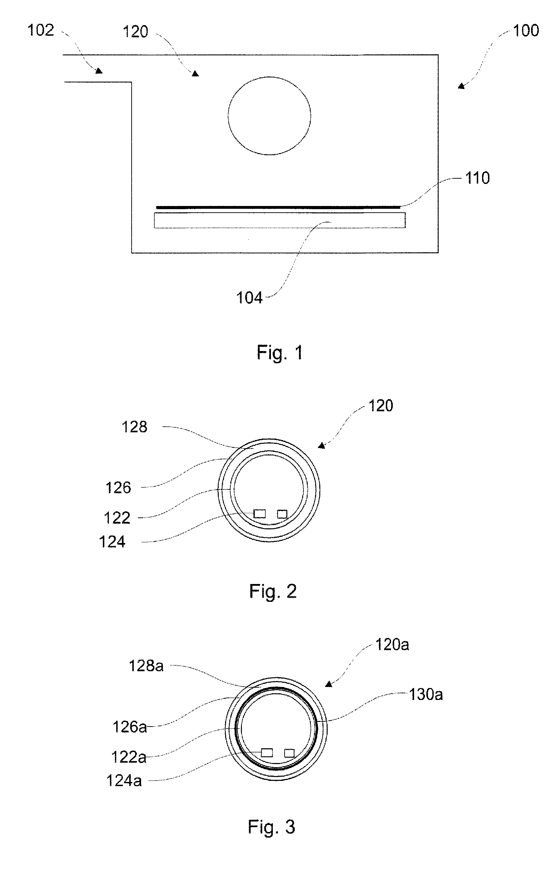

Fig. 1 shows a vacuum chamber 100 including a gas inlet 102 for providing processing gas, for example argon, to the vacuum chamber. The vacuum chamber further includes a substrate support 104 and a substrate 110 arranged on the substrate support 104. Further, the vacuum chamber 100 includes a rotating cylindrical target assembly 120, typically in a cantilevered arrangement above the substrate 110. In operation, the cylindrical target assembly 120 rotates about its longitudinal axis and a plasma of predetermined particles, for example argon ions, is generated between the cylindrical target assembly 120 and the substrate 110. These charged particles are accelerated against target elements of the cylindrical target assembly 120, such that particles of the cylindrical target assembly are sputtered and subsequently deposited on the substrate 110. In a further embodiment, the vacuum chamber may include one or more openings and/or valves for introducing or retracting the substrate in or out of the vacuum chamber. Even though Fig. 1 shows one target assembly, according to different embodiments, which may be combined with other embodiments disclosed herein, the vacuum chamber includes a plurality of, for example two or more, rotating cylindrical target assemblies.

Fig. 2 shows an example of a cylindrical target assembly in cross sectional view. The cylindrical target assembly 120 includes a backing tube 122, in which magnetrons 124 are disposed for generating the plasma within the vacuum chamber 100 between the target assembly 120 and the substrate 110. Target elements 126 are provided around the backing tube 122. Typically, the target elements have a cylindrical form. The target elements provide the material to be sputtered on the substrate. Thus, the longer the coating process is taking place, the more material is "lost" from the target elements. In operation, the cylindrical target assembly rotates about its longitudinal axis such that the material of the target elements is worn or sputtered regularly about its circumference.

In a typical embodiment, which may be combined with other embodiments disclosed herein, the target elements 126 are not bonded to the backing tube 122. For example, spacers or springs or other elements may be used for centering the target elements on the backing tube 122. Typically, in an embodiment, a plurality of target elements, for example two or more, is arranged side by side around the backing tube 122. The number and the kind of target elements may depend on the material to be sputtered and the length or form of the backing tube.

The temperature of the material of the target elements 126 may be controlled in a typical embodiment in order to avoid nodules or pickles on the substrate to be coated.

Typically, heat is generated during deposition operations. For example plasma has to be generated and, in some embodiments the substrate to be coated may be heated. However, the magnetrons 124 have to be cooled such that they do not loss their magnetic characteristics due to high temperatures. Thus, in typical embodiments, which may be combined with other embodiments disclosed herein, the backing tube 122 is cooled inside. For example, the cooling may be performed with a water circuit within the backing tube 122.

As already explained here above, the control of the temperature of the target elements 126 may be important. Typically, the backing tube 122 is cooled, such that a cooling of the target elements 126 relates to the heat transfer between the backing tube 122 and the target elements 126. Thereby, an important factor to be considered for the disclosed embodiments is the fact that the target elements and the backing tube are located in a vacuum environment, for example in the vacuum chamber 100. According to typical embodiments, which can be combined with other embodiments described herein, the pressure in the plasma area can be 10⁻⁴ to 10⁻² mbar, typically about 10⁻³ mbar.

Thus, in a typical embodiment, there are substantially no particles or atoms between the outer surface of the backing tube 122 facing the target elements and the inner surface of the target elements 126 facing the backing tube 122. Even, if a heat conductive layer having a high thermal conductivity, for example a metal layer, would be used, the heat conductivity of the metal layer, e.g. a copper layer would only cool the target elements 126 if the target elements 126 and the intermediate layer would be press fitted on the backing tube.. Typically, when ITO (Indium Titan Oxide) targets elements are used, such a pressure is difficult to provide. Further, the target elements may expand and retract due to high temperature differences before and during the sputtering process. Thus, as there is no contact pressure, a metal layer between the target element 126 and the backing tube 122 would act rather as a shield, such that the heat transfer between the target elements 126 and the backing tube 122 is reduced.

Typically, under vacuum a heat transfer contact cannot be established well without a contact pressure. The contact pressure depends on the contact with respect on a scale of the surface roughness of the contacting surfaces.

Typically, a gap 128 is provided between the target elements 126 and the backing tube 122. Such a gap 128 may be provided for assembling and disassembling the target elements 126 from the backing tube 122, for example for exchanging the target elements 126 after the target elements are used up or another deposition material has to be used. According to some embodiments, which may be combined with other embodiments herein, the gap may have a width in radial direction between 0.1 mm and about 3 mm, typically between 0.2 mm and 2 mm.

According to Stefan-Boltzmann law the total energy radiated per unit surface area of a black body is proportional to the fourth power of the black body's temperature T (absolute temperature). In a case of a gray body, that is a body that does not absorb or emit the full amount of radiative flux, the gray body radiates only a portion of the radiative flux that is characterized by its emissivity ε. Typically, the absorbed irradiance is also proportional to the fourth power of the temperature of the surrounding.

Commonly, a backing tube is formed by a stainless steel which has typically an ε-value of about 0.2.

According to embodiments describe herein, which may be combined with other embodiments disclosed herein, a portion of at least 50%, in particular more than 70%, of the exterior surface of the backing tube facing the inner surface of the target elements and/or a portion of at least 50%, in particular more than 70%, of the interior surface of the target elements facing the backing tube has a mean ε-value that is greater than 0.7, for example between 0.8 and 1.

Fig. 3 shows a cross-section of an embodiment of a cylindrical target assembly 122a having a backing tube 122a and at least one target element 126a. The backing tube 122a has an outer surface facing the target elements 126a that is coated with a material having an ε-value of more than 0.8. For example, a stainless steel surface of the backing tube 122a may be coated in an embodiment, which may be combined with other embodiments disclosed herein, with TiO₂ such that the ε-values of the coated backing tube is about 0.88. Compared with a stainless steel backing tube without a coating, the emissivity is multiplied by about factor 4. Fig. 3 shows a coating 130a applied on the backing tube 122a. Thus, the heat transfer from the target element 126a to the backing tube 122a, which is cooled, is improved.

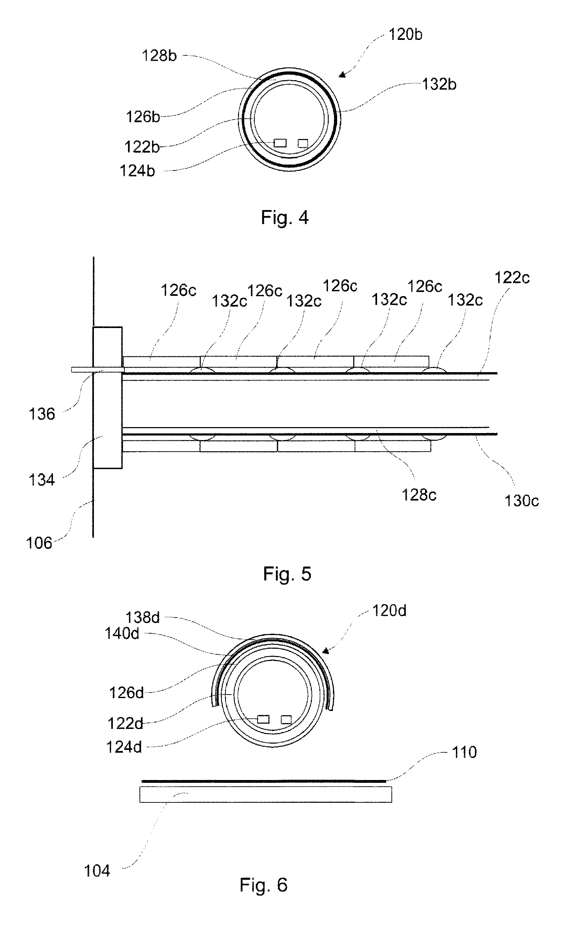

Fig. 4 shows a further embodiment, which may be combined with other embodiments disclosed herein, of a cylindrical target assembly 122b. The cylindrical target assembly 122b includes a backing tube 122b in which the magnetrons 124b are disposed. Further, the cylindrical target assembly 122b, includes a target element 126b having an outer surface from which the material is removed during the sputtering process and an inner surface facing the backing tube 122b on which a coating 132b is disposed. The coating 132b has a greater emissivity than the inner surface of the target elements without the coating 132b. In a typical embodiment, which may be combined with other embodiments herein, the emissivity of the coating 132b is from about 0.8 to 1. For example, a coating of TiO₂ may be applied to the inner surface of the target element to improve the emissivity of the target element with respect to the backing tube.

According to yet further embodiments, which may be combined with other embodiments disclosed herein, the backing tube has on its outer or exterior surface a coating for improving the emissivity and the target elements have a coating on their inner or interior surface to improve the emissivity. Thus, the heat transfer from the target element to the backing tube is further improved.

According to yet further embodiments, which may be combined with other embodiments herein, the surfaces one or more of the following group: the backing tube, the target element, a coating on the backing tube; and a coating on the target element, can be provided or configured to have a roughness to improve the heat transfer between the target element and the backing tube. For example, the roughness (R_{z}) may be greater than 50, in particular greater than R_{z} 100.

Fig. 5 shows a longitudinal cross section of an embodiment of a cylindrical target assembly 120c. The target assembly includes a backing tube 120c which is coated on its exterior surface with a coating 130c for improving the emissivity of the backing tube 120c. In a further embodiment, the exterior surface of the backing tube is not coated. A number of target elements 126 is disposed around the backing tube and are centered with springs 132c. Further, the backing tubes are arranged side by side and pushed against a stop 134 which is arranged at a wall 106 of a vacuum chamber. Between the backing tube and the target elements a gap 128c is provided. The gap may have a width in radial direction between 0.1 mm and about 3 mm, typically between 0.2 mm and 2 mm.

According to some embodiments, which can be combined with other embodiments described herein, a heat transfer gas can be provided through a heat transfer gas inlet 136, e.g., arranged in the stop 134. The heat transfer gas at an increased pressure of, for example, 0.1 to 10 mbar may improve the heat transfer between the target element 126c and the backing tube 120c in addition to the heat radiation improved basd on emissivity. The heat transfer gas inlet is arranged such that the gas enters the gap 128c between the target elements 126 and the backing tube 120c. For example, the heat transfer gas may be argon, helium or another gas that does not disturb the deposition procedure of the substrate in the vacuum chamber. For example, the pressure between the backing tube and the target elements could be, in an embodiment which may be combined with other embodiments disclosed herein at about 1 mbar. The pressure in the vacuum chamber is typically less than about 1 x 10⁻² mbar, typically about 1 x 10⁻³ mbar.

In a further embodiment, the gap 128c between the target elements and the backing tube is sealed with respect to the vacuum chamber such that the heat transfer gas does substantially not enter the vacuum chamber. However, some loss of gas might be acceptable, for example between two of the target elements 126c, if the heat transfer gas may be used as a process gas for creating the plasma in the vacuum chamber 100. For example, argon may be used as a heat transfer gas and as a carrier gas for creating the plasma between the cylindrical target assembly and the substrate.

Fig. 6 shows a further embodiment of a cylindrical target assembly 120d. In Fig. 6, the cylindrical target assembly 120d includes a backing tube, in which magnetrons 124d are disposed for generating plasma between the substrate 110 and the cylindrical target assembly 120d. A plurality of target elements 126d are disposed around the backing tube 122d of the cylindrical target assembly 120d. As described here-above with respect to figures 3 to 5, according to some embodiments, which may be combined with other embodiments disclosed herein, the exterior surface of the backing tube or the interior surface of the cylindrical target elements may include a coating for improving the heat transfer from the target elements 126d to the backing tube 122d. According to yet further embodiments, additionally or alternatively to the cooling due to emissivity of the exterior surface of the backing tube or the interior surface of the cylindrical target elements, a cooling shield 138d is arranged around the target elements at the opposite side to the substrate 110 with respect to the backing tube 122d and the target elements 126d. In the cross section, the cooling shield 138d surrounds substantially 30% to 75% of the target elements, in particular 50% to 60 % of the target elements, wherein the remaining non-covered parts are directed to the substrate 110 to be coated. In a typical optional modification, at least 50%, in particular at least 70%, of the surface of the cooling shield 138d facing the target elements 126d, in particular the interior surface, has a mean ε-value of about 0.7 to 1, in particular of 0.8 to 1. For example, the surface directed to the target elements 126d can be covered with a coating 140d which has a mean ε -value, in particular between 0.8 and 1. The coating may be in a typical embodiment TiO₂. In another embodiment, the coating may be selected of the group consisting of CrO, TiO₂, Carbon, Graphite, and any combination thereof. According to a further embodiment, the surface of the cooling shield 138d directed to the target elements 126d can be roughened. In a further embodiment, which may be combined with other embodiments disclosed herein, the coating 140d may be roughened, in particular to enhance the heat transfer from the target elements 126d to the cooling shield. In another embodiment, the at least 50% of the surface of the cooling shield directed to the target elements is roughened.

According to the embodiment shown in Fig. 6, the heat of the target elements 126d is not only transferred to the cooled backing tube 122d, but also to the cooling shield 138d, which is placed on the other side of the cylindrical target assembly with respect to the plasma between the cylindrical target assembly and the substrate to be coated. Thus, an efficient cooling of the target elements 126d is provided.

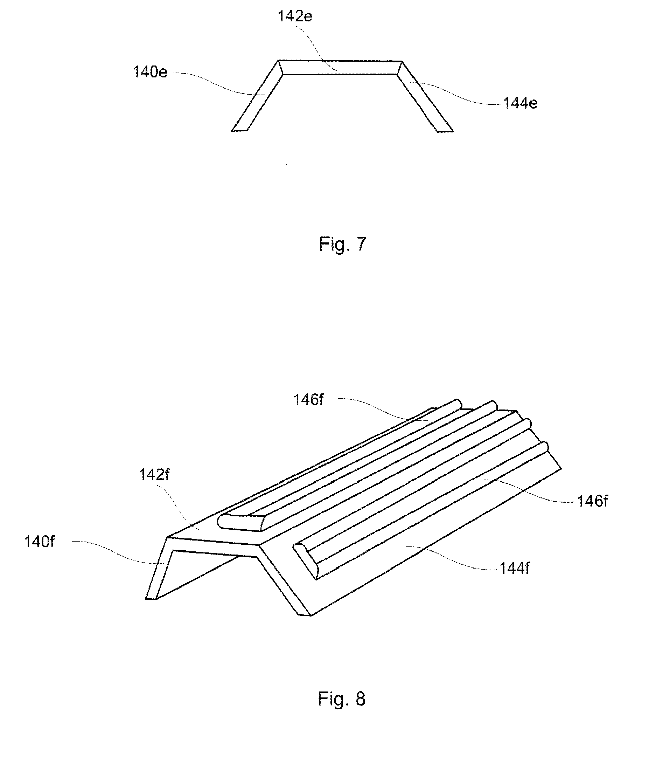

Fig. 7 shows schematically a further embodiment of a cooling shield in a cross section. The cooling shield includes a plurality of flat planes 140e, 142e, 144e, for example two, three or more planes, that are formed, such that they partly surround a cylindrical target assembly. For example, each plane may be formed by a separate flat metal plate, wherein the metal plates are welded together to form the cooling shield. In another embodiment, the cooling shield is formed of a sheet metal which is bended to form the flat planes. The cooling shield of Fig. 7 may be treated in a similar way than the cooling shield of the embodiment shown in Fig. 6. Thus, according to some typical embodiments, at least 50%, in particular at least 70% or at least 90%, of the surface facing towards the cylindrical target assembly is coated with a coating having a high ε-value, for example a mean ε-value between 0.7 and 1, in particular between 0.8 and 1. In another embodiment, the surface facing towards the cylindrical target assembly may be roughened.

Fig. 8 shows schematically a perspective view of another embodiment of a cooling shield. The cooling shield includes a plurality of flat planes 140f, 142f, 144f, for example two, three or more planes, that are formed, such that they partly surround a cylindrical target assembly. The cooling shield has an interior surface adapted to face the target elements and an exterior surface opposite to the interior surface. In a typical embodiment, which may be combined with other embodiments disclosed herein, at least 50%, in particular at least 70%, of the interior surface of the cooling shield has a mean ε-value of about 0.7 to 1, in particular of 0.8 to 1. In another embodiment, at least 50%, in particular at least 70% of the surface facing towards the cylindrical target assembly is coated with a coating having a high ε-value, for example a mean ε-value between 0.7 and 1. In another embodiment, the interior surface may be roughened. The cooling shield of Fig. 8 is actively cooled. For example, at least one tube 146f, in particular two, three or more tubes, is disposed on the cooling shield shown in Fig. 8 for circulating a cooling fluid or a cooling liquid, for example water.

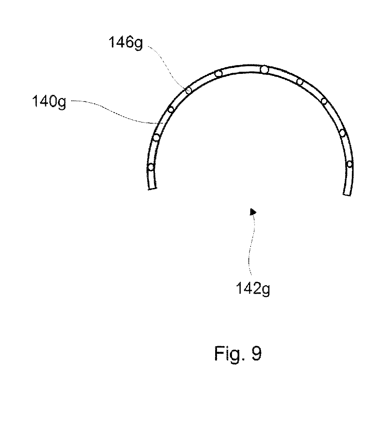

Fig. 9 shows a cross-section of a further embodiment of a cooling shield 140g. The cooling shield 140g has a form of a portion of a cylinder having an opening 142g in its surface directed to the substrate to be coated (not shown in Fig. 9). At least one tube146g, for example two, three or more tubes, is disposed within the cooling shield.

The tube(s) 146f, 146g may be connected, in a typical embodiment, which may be combined with other embodiments disclosed herein, to a cooling circuit used for cooling the magnetrons in the backing tube.

According to some embodiments, which may be combined with other embodiments disclosed herein, a cooling shield may be provided, such that it surrounds the cylindrical target assembly at a radial position for which no sputtering is conducted.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A target backing tube (122a, 122c) for a rotatable cylindrical target assembly (120a) comprising:
a tube for at least one target element to be disposed there around, wherein the tube has an exterior surface adapted to face the at least one target element,
wherein a portion of the exterior surface of the tube has a mean emissivity of 0.7 to 1, wherein the portion is at least 50% of the exterior surface of the tube.

2. A target element (126b) for a rotatable cylindrical target assembly (120b) of a sputtering system, wherein
the target element an interior surface adapted to face a target backing tube onto which the target cylinder is adapted to be disposed and exterior surface, wherein a portion of the interior surface of the target element has a mean emissivity of 0.7 to 1, wherein the portion is at least 50% of the interior surface of the target element.

3. The target cylinder according to claim 2, wherein the target element is selected from the group consisting of an indium-tin oxide (ITO) target element, an SnO target, an AlSnO target element, and an InGaSnO target element.

4. A cooling shield (138d) for a sputtering system comprising a rotatable target (126d), the cooling shield has an interior surface adapted to face a target element of a sputtering system and an exterior surface; wherein a portion of the interior surface of the cooling shield has a mean emissivity of 0.7 to 1, wherein the portion is at least 50% of the interior surface of the cooling shield.

5. The cooling shield according to claim 4, further comprising at least one active cooling device (146f), in particular disposed on the exterior surface of the cooling shield or in the cooling shield, wherein in particular the cooling device is a tube for circulating a cooling fluid and/or an electrical cooling device.

6. The cooling shield according to one of the claims 4 to 5, the target backing tube according to claim 1, and/or the target element according to claim 2 or 3, wherein the portion is at least 70%, in particular at least 90%, of the interior surface of the cooling shield.

7. The cooling shield according to one of the claims 4 to 6, the target backing tube according to claim 1 or 6, and/or the target element according to one of the claims 2, 3 and 6, wherein the portion of the surface of the cooling shield has a coating (130a, 130c, 132b, 140d) presenting the mean emissivity of 0.7 to 1.

8. The cooling shield according to one of the claims 4 to 7, the target backing tube according to one of the claims 1, 6 and 7, and/or the target element according to one of the claims 2, 3, 6 and 7, wherein
the portion of the interior surface of the cooling shield is coated with a material selected from the group consisting of TiO₂, CrO, Carbon, Graphite, and any combinations thereof.

9. The cooling shield according to one of the claims 4 to 8, the target backing tube according to one of the claims 1, 6 to 8, and/or the target element according to one of the claims 2, 3, 6 to 8, wherein
the portion of the interior surface of the cooling shield has a roughness between R_{z} 20 and R_{z} 500, in particular between R_{z} 50 and R_{z} 250.

10. A rotatable cylindrical target assembly (120, 120a, 120b, 120d) comprising:
a target backing tube according to one of the claims 1, and 6 to 9,
and at least one target element disposed around the backing tube, wherein in particular the at least one target element is a target element according to one of the claims 2, 3, and 6 to 9.

11. The rotatable cylindrical target assembly according to claim 10, further comprising a heat transfer gas inlet adapted for providing a heat transfer gas in a space between the exterior surface of the backing tube and the interior surface of the target element, wherein in particular the space is sealed with respect to a surrounding of the rotatable cylindrical target assembly, in particular a vacuum chamber in which the rotatable cylindrical target assembly is disposed.

12. The rotatable cylindrical target assembly according to claim 11, wherein the gas is selected from the group consisting of Argon, Helium, process gases, and any combinations thereof.

13. A sputtering system (100) comprising:
a rotatable cylindrical target assembly (120, 120a, 120b, 120d) comprising a target backing tube (122, 122a, 122b, 122c, 122d)and at least one target element (126, 126a, 126b, 126c, 126d) disposed around the target backing tube, and
at least one cooling shield according to one of the claims 4 to 9, wherein the cooling shield (138d) is provided to surround the at least one target element at a radial position substantially opposite to a substrate to be coated by sputtering.

14. The sputtering system according to claim 13, wherein
the distance between the inner surface of the cooling shield and the outer surface of the at least one target cylinder is about 5 to 200 mm, in particular between 50 and 100 mm.

15. The sputtering system according to one of the claims 13 or 14, wherein the cooling shield (138d) surrounds substantially 30 to 80 % of the circumference of the at least one target cylinder, in particular 40 to 60%.

## Amended claims

### Amended claims in accordance with Rule 137(2) EPC.

**1.** A target backing tube (122a, 122c) for a rotatable cylindrical target assembly (120a) comprising:
a tube for at least one target element to be disposed there around, wherein the tube has an exterior surface adapted to face the at least one target element,
wherein a portion of the exterior surface of the tube has a mean emissivity of 0.7 to 1, wherein the portion is at least 50% of the exterior surface of the tube,
wherein the portion has a coating (130a, 130c) presenting the mean emissivity of 0.7 to 1.

**2.** A target element (126b) for a rotatable cylindrical target assembly (120b) of a sputtering system, wherein
the target element an interior surface adapted to face a target backing tube onto which the target cylinder is adapted to be disposed and exterior surface, wherein a portion of the interior surface of the target element has a mean emissivity of 0.7 to 1, wherein the portion is at least 50% of the interior surface of the target element, wherein the portion has a coating (132b) presenting the mean emissivity of 0.7 to 1.

**3.** The target element according to claim 2, wherein the target element is selected from the group consisting of an indium-tin oxide (ITO) target element, an SnO target, an AlSnO target element, and an InGaSnO target element.

**4.** A cooling shield (138d) for a sputtering system comprising a rotatable target (126d), the cooling shield has an interior surface adapted to face a target element of a sputtering system and an exterior surface; wherein a portion of the interior surface of the cooling shield has a mean emissivity of 0.7 to 1, wherein the portion is at least 50% of the interior surface of the cooling shield, wherein the portion has a coating (140d) presenting the mean emissivity of 0.7 to 1.

**5.** The cooling shield according to claim 4, further comprising at least one active cooling device (146f), in particular disposed on the exterior surface of the cooling shield or in the cooling shield, wherein in particular the cooling device is a tube for circulating a cooling fluid and/or an electrical cooling device.

**6.** The cooling shield according to one of the claims 4 to 5, the target backing tube according to claim 1, and/or the target element according to claim 2 or 3, wherein the portion is at least 70%, in particular at least 90%, of the interior surface of the cooling shield.

**7.** The cooling shield according to one of the claims 4 to 6, the target backing tube according to one of the claims 1 and 6, and/or the target element according to one of the claims 2, 3 and 6, wherein
the portion of the surface is coated with a material selected from the group consisting of TiO₂, CrO, Carbon, Graphite, and any combinations thereon

**8.** The cooling shield according to one of the claims 4 to 8, the target backing tube according to one of the claims 1, 6 to 8, and/or the target element according to one of the claims 2, 3, 6 to 8, wherein
the portion of the surface has a roughness between R_{z} 20 and R_{z} 500, in particular between R_{z} 50 and R_{z} 250.

**9.** A rotatable cylindrical target assembly (120, 120a, 120b, 120d) comprising:
a target backing tube comprising a tube for at least one target element to be disposed there around, wherein the tube has an exterior surface adapted to face the at least one target element, wherein a portion of the exterior surface of the tube has a mean emissivity of 0.7 to 1, wherein the portion is at least 50% of the exterior surface of the tube, and
and at least one target element disposed around the backing tube, wherein a gap (128) is provided between the at least one target element and the backing tube.

**10.** The rotatable cylindrical target assembly according to claim 9, wherein
the target backing tube is a target backing tube according to one of the claims 1, and 6 to 8, and/or
the at least one target element is a target element according to one of the claims 2, 3, and 6 to 8.

**11.** The rotatable cylindrical target assembly according to claim 9 or 10, further comprising a heat transfer gas inlet adapted for providing a heat transfer gas in a space between the exterior surface of the backing tube and the interior surface of the target element, wherein in particular the space is sealed with respect to a surrounding of the rotatable cylindrical target assembly, in particular a vacuum chamber in which the rotatable cylindrical target assembly is disposed.

**12.** The rotatable cylindrical target assembly according to claim 11, wherein the gas is selected from the group consisting of Argon, Helium, process gases, and any combinations thereof.

**13.** A sputtering system (100) comprising:
a rotatable cylindrical target assembly (120, 120a, 120b, 120d) comprising a target backing tube (122, 122a, 122b, 122c, 122d)and at least one target element (126, 126a, 126b, 126c, 126d) disposed around the target backing tube, and
at least one cooling shield according to one of the claims 4 to 8, wherein the cooling shield (138d) is provided to surround the at least one target element at a radial position substantially opposite to a substrate to be coated by sputtering.

**14.** The sputtering system according to claim 13, wherein
the distance between the inner surface of the cooling shield and the outer surface of the at least one target cylinder is about 5 to 200 mm, in particular between 50 and 100 mm.

**15.** The sputtering system according to one of the claims 13 or 14, wherein the cooling shield (138d) surrounds substantially 30 to 80 % of the circumference of the at least one target cylinder, in particular 40 to 60%.
